(19) Europäisches Patentamt
European Patent Office
Office européen des brevets

(11) **EP 2 175 287 B1**

(12) **EUROPÄISCHE PATENTSCHRIFT**

(45) Veröffentlichungstag und Bekanntmachung des Hinweises auf die Patenterteilung:
**06.11.2013 Patentblatt 2013/45**

(51) Int Cl.:
***G01R 19/25*** *(2006.01)*

(21) Anmeldenummer: **09011578.3**

(22) Anmeldetag: **10.09.2009**

(54) **Vorrichtung und Verfahren zur Messung elektrischer Kenngrößen**

Device and method for measuring electrical parameters

Dispositif et procédé de mesure de grandeurs électriques

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **11.10.2008 DE 102008051421**

(43) Veröffentlichungstag der Anmeldung:
**14.04.2010 Patentblatt 2010/15**

(73) Patentinhaber: **Robert Bosch GmbH**
**70469 Stuttgart (DE)**

(72) Erfinder: **Wolz, Frank, Dr.**
**97877 Wertheim-Bettigheim (DE)**

(74) Vertreter: **Thürer, Andreas**
**Bosch Rexorth AG**
**Zum Eisengießer 1**
**97816 Lohr am Main (DE)**

(56) Entgegenhaltungen:
**US-A- 5 485 393    US-B1- 6 417 792**

• **SREELAL S P ET AL: "A high resolution, integrated data acquisition system for aerospace applications", DIGITAL AVIONICS SYSTEMS CONFERENCE, 2004. DASC 04. THE 23RD SALT LAKE CITY, UT, USA 24-28 OCT. 2004, PISCATAWAY, NJ, USA,IEEE, US, 24. Oktober 2004 (2004-10-24), Seiten 13.E.3-131, XP010765203, ISBN: 978-0-7803-8539-9**

**Beschreibung**

Die vorliegende Erfindung bezieht sich auf eine Vorrichtung und ein Verfahren zur Messung von elektrischen Kenngrößen und insbesondere von elektrischen Strömen oder Spannungen.

Aus dem Stand der Technik ist es bekannt, sogenannte Sigma-Delta-Verfahren zur Messung von elektrischen Strömungen oder Spannungen einzusetzen. Die Vorteile dieses Verfahrens liegen in einer hohen Abtastrate sowie auch in einem schmalen Interface zwischen der Abtasteinheit d. h. einem Sigma-Delta-Modulator und der Auswertelogik, da lediglich eine Takt- und eine Datenleitung zur Übertragung der Messergebnisse erforderlich sind.

Falls mehrere Messkanäle bzw. mehrere Sigma-Delta-Modulatoren vorliegen, sind in der Regel auch mehrere Auswertelogiken erforderlich. Diese Vielzahl von Auswertelogiken bringt andererseits einen erhöhten Aufwand mit sich.

Die Druckschrift SREELAL S P ET AL: "A high resolution, integrated data acquisition system for aerospace applications", DIGITAL AVIONICS SYSTEMS CONFERENCE, 2004. DASC 04. THE 23RD SALT LAKE CITY, UT, USA 24-28 OCT. 2004, PISCATAWAY, NJ. USA, IEEE, US, 24. Oktober 2004, Seiten 13.E.3-131, ISBN: 978-0-7803-8539-9 zeigt ein hoch-auflösendes Datenaufnahmesystem für Luftfahrtanwendungen.

Der vorliegenden Erfindung liegt daher die Aufgabe zugrunde, eine Vorrichtung und ein Verfahren zur Verfügung zustellen, welches den Aufwand zur Messung der elektrischen Kenngrößen reduziert. Dies wird durch die Gegenstände der unabhängigen Vorrichtungs- und Verfahrensansprüche erreicht. Vorteilhafte Ausführungsformen und Weiterbildungen sind Gegenstand der Unteransprüche.

Eine erfindungsgemäße Vorrichtung zur Messung elektrischer Kenngrößen weist eine erste Wandlereinheit auf, welche analoge Signale in digitale Daten wandelt, wobei die erste Wandlereinheit bevorzugt ein Sigma-Delta-Modulator ist. Weiterhin ist eine zweite Wandlereinheit vorgesehen, welche analoge Signale in digitale Daten umwandelt, wobei die zweite Wandlereinheit ebenfalls bevorzugt ein Sigma-Delta-Modulator ist und wenigstens einer Auswertelogik zur Bearbeitung der von den Wandlereinheiten ausgegebenen Signale, wobei die Auswertelogik mindestens ein Integrationsglied und ein diesem Integrationsglied nachgeschaltetes Differenzierglied aufweist.

Erfindungsgemäß verarbeitet die Auswertelogik die digitalen Signale beider Wandlereinheiten und die Wandlereinheiten weisen jeweils Eingänge für ein Taktsignal auf, wobei eine Taktgebereinrichtung vorgesehen ist, welche die erste Wandlereinheit und die zweite Wandlereinheit in einem vorgegebenen Verhältnis zueinander und vorzugsweise gleich taktet.

Im Rahmen der vorliegenden Erfindung wird damit eine Auswertelogik und insbesondere eine sogenannte Sinc-Filter basierte Auswertelogik vorgestellt, die es erlaubt, Datenströme mehrerer Sigma-Delta-Modulatoren zu verarbeiten, in dem insbesondere eine Pipeline basierte Architektur angewandt wird. Dabei liegt bevorzugt die Latenz der einzelnen Kanäle lediglich im Bereich weniger Einheiten eines schnellen Taktes der Auswertelogik. Durch die Eingänge für das Taktsignal, d.h. hier den Einsatz von Sigma-Delta-Modulatoren mit einem Takteingang wird die erfinderische Vorgehensweise gestützt. Damit erfolgt hier eine mehrkanalige Sigma-Delta Datenstromauswertung, bevorzugt nach dem Sinc-Filter-Prinzip, insbesondere für programmierbare Logikbausteine. Es wird damit eine simultane Auswertung der Datenströme mehrerer Sigma-Delta-Modulatoren vorgeschlagen und genauer eine ressourceneffiziente mehrkanalige Realisierung eines Sinc - Filters.

Vorzugsweise weist die Auswertelogik wenigstens ein adressierbares Speicherelement auf. Dieses adressierbare Speicherelement kann dabei beispielsweise einem Integrationsglied nachgeschaltet werden und erlaubt es, hintereinander eingelesene Daten unterschiedlichen Adressen zuzuordnen, wodurch eine Zuordnung zu den einzelnen Sigma-Delta-Modulatoren ermöglicht wird (Multiplexing).

Damit ist bevorzugt das adressierbare Speicherelement einer Integrationseinheit der Auswertelogik nachgeschaltet und insbesondere unmittelbar nachgeschaltet. Dieses Speicherelement dient damit dem Einlesen von n Bitwerten. Bei einer weiteren vorteilhaften Ausführungsform sind mehrere adressierbare Speicherelemente vorgesehen und diese Speicherelemente werden mit dem gleichen Takt betrieben. So ist es beispielsweise möglich, dass nach jeder Integrationsstufe ein entsprechendes adressierbares Speicherelement vorgesehen wird, so dass die eingelesenen Daten auf diese Weise alle Integrationsstufen durchlaufen können.

Vorzugsweise ist als Auswertelogik ein Sinc - Filter mit einer vorgegebenen Ordnung vorgesehen, wobei diese Ordnung größer als 1 ist.

Aufgrund der hohen Überabtastung bei einer Sigma-Delta-Wandlung entsteht in einem im Frequenzbereich oberhalb einer Frequenz $f_{in}$ (der Bandbreite) durch die Quantisierung ein Rauschen, das mittels eines digitalen Tiefpassfilters abgedämpft wird. Weiterhin wird eine serielle Bitfolge durch einen sogenannten Dezimierer in b Bit breite Datenworte umgewandelt. Diese beiden Aufgaben werden durch den Einsatz eines Sinc - Filters gelöst.

Bei einer weiteren vorteilhaften Ausführungsform sind die Wandlereinheiten gleich getaktet. Dabei ist es auch möglich, anstelle der hier beschriebenen zwei Sigma-Delta-Modulatoren mehrere, d.h. mehr als zwei, auch mehr als fünf oder auch mehr als acht Sigma-Delta-Modulatoren vorzusehen. Das Verfahren ist im Prinzip auf eine beliebige Anzahl von Sigma-Delta-Modulatoren erweiterbar. Beschränkungen der Anzahl von Messkanälen ergeben sich insbesondere aus dem Sigma-Delta-Takt, dem Systemtakt der Auswertelogik sowie der Adressiertiefe der Speicherelemente.

Weiterhin weist bevorzugt die Vorrichtung eine Speichereinrichtung zum vorübergehenden Speichern der digitalen Daten auf. Bei dieser Speichereinrichtung kann es sich beispielsweise um ein Schieberegister handeln, welches der ersten Integrierstufe vorgeschaltet ist. In dieses Schieberegister können die digitalen Daten parallel eingelesen werden und anschließend getaktet und seriell aus dieser Speichereinheit ausgelesen werden. Dieses Schieberegister sammelt die Daten für die systemtaktweise Zuführung zu einer Verarbeitungspipeline.

Vorzugsweise weist die Auswertelogik mehrere Integrationseinheiten auf und jeder dieser Integrationseinheiten ist ein adressierbares Speicherelement zugeordnet bzw. nachgeschaltet.

Vorzugsweise ist auch wenigstens einem Differenzierglied und bevorzugt jedem Differenzierglied jeweils ein Speicherelement und bevorzugt ein adressierbares Speicherelement nachgeschaltet. Dabei wird bevorzugt wenigstens ein Adresseingang dieses adressierbaren weiteren Speicherelements mit einem anderen Takt ,und insbesondere mit einem um eine Potenz der Zahl 2, der sog. "Dezimation", geteilten Sigma-Delta-Takt, betrieben als das oben erwähnte adressierbare Speicherelement, welches der Integrationseinheit nachgeschaltet ist.

Vorzugsweise wird das adressierbare Speicherelement, welches dem Differenzierglied nachgeschaltet ist, mit einem geringeren Takt betrieben als ein Speicherelement, welches einem Integrationsglied nachgeschaltet ist. Vorzugsweise ist zwischen den Integrationsgliedern und insbesondere dem letzten Integrationsglied der Kette und den Differenziergliedern d.h. bevorzugt dem ersten Differenzierglied ein Multiplexer angeordnet. Auch dieser Multiplexer wird dabei getaktet und insbesondere mit demjenigen Takt getaktet, mit dem auch die oben erwähnten Eingänge der den Differenziergliedern nach geschalteten adressierbaren Speicherelemente getaktet werden. Diese Multiplexer - Einheit nach dem letzten Integrationsglied bewirkt, das nach Ablauf eines jeden Zyklus, genauer, jedes Zyklusses des dezimierten Sigma-Delta-Taktes der in einem Speicherelement enthaltene Zwischenwert des letzten Integrationsglieds zurückgestellt (resetiert) wird.

Die vorliegende Erfindung ist weiterhin auf eine Auswertelogik zur Auswertung von digitalen Ausgangssignalen mehrerer Wandlereinrichtungen gerichtet, wobei die Auswertelogik mindestens ein Integrationsglied und ein diesem Integrationsglied nach geschaltetes Differenzierglied aufweist. Erfindungsgemäß bearbeitet die Auswertelogik die digitalen Signale bzw. Daten beider Wandlereinheiten und die Wandlereinheiten weisen jeweils Eingänge für ein Taktsignal auf, wobei eine Taktgebereinrichtung vorgesehen ist, welche die erste Wandlereinheit und die zweite Wandlereinheit in einem vorgegebenen Verhältnis zueinander taktet.

Bevorzugt taktet die gleiche Taktgebereinheit auch wenigstens ein Element der Auswertelogik mit dem gleichen Takt, mit dem auch die Wandlereinrichtungen getaktet werden. Damit laufen hier über die Integrationsglieder und Differenzierglieder der Auswertelogik die Daten aller Wandlereinheiten.

Die vorliegende Erfindung ist weiterhin auf ein Verfahren zur Bestimmung elektrischer Kenngrößen gerichtet. Dabei werden im ersten Schritt mehrere digitale Daten bereit gestellt, welche für die elektrischen Kenngrößen charakteristisch sind, wobei diese Daten durch wenigstens durch eine erste Wandlereinrichtung und wenigstens eine zweite Wandlereinrichtung zur Verfügung gestellt werden.

Weiterhin werden die digitalen Daten an eine Auswertelogik zugeführt, welche wenigstens ein Integrationsglied und wenigstens ein diesem Integrationsglied nach geschaltetes Differenzierglied aufweist und anschließend werden die Signale durch die Auswertelogik bearbeitet. Schließlich wird ein Signal durch die Auswertelogik ausgegebenen, wobei dieses Signal für die elektrische Kenngröße charakteristisch ist.

Erfindungsgemäß verarbeitet die gleiche Auswertelogik die Signale beider Wandlereinheiten und die Wandlereinheiten weisen jeweils Eingänge für ein Taktsignal auf, wobei eine Taktgebereinrichtung die erste Wandeleinheit und die zweite Wandeleinheit in einem vorgegebenen Verhältnis zueinander und insbesondere gleich (d.h. mit dem gleichen Takt) taktet. Es wäre jedoch auch denkbar, dass die Wandlereinrichtungen in einem anderen festgelegten und insbesondere auch konstant bleibenden Verhältnis getaktet werden, beispielsweise gegenläufig.

Vorzugsweise werden die Daten mehrerer Wandlereinrichtungen parallel in ein Schieberegister geladen. Aus diesem Schieberegister werden die Daten, wie oben erwähnt, seriell in die Auswertelogik bzw. in ein erstes Integrationsglied dieser Auswertelogik geladen.

Bei einem weiteren bevorzugten Verfahren werden die Daten oder aus diesen Daten abgeleitete Daten einem ersten Integrationsglied getaktet zugeführt, wobei mit jedem Takt eine Adresse einer diesem Integrationsglied nach geschalteten adressierbaren Speichereinrichtung verändert wird. Durch diese Vorgehensweise ist eine Individualisierte d.h. nach Wandeleinrichtungen aufspaltbare Speicherung der Daten möglich.

Bei einem weiteren vorteilhaften Verfahren wird wenigstens ein einem Differenzierglied nach geschaltetes Speicherelement mit einem anderen Takt betrieben als die erwähnte adressierbare Speichereinrichtung.

Weitere Vorteile und Ausführungsformen ergeben sich aus den beigefügten Zeichnungen:

Darin zeigen:

Fig. 1    Ein Schaltdiagramm eines Sigma-Delta-Modulators;

Fig. 2     Signalkurven zur Veranschaulichung von Signalen, welche durch einen Sigma-Delta-Modulator verarbeitet werden;

Fig. 3     ein Schaltbild eines Sinc - Filters dritter Ordnung nach dem Stand der Technik;

Fig. 4     Ein Schaltbild eines erfindungsgemäßen Sinc - Filters dritter Ordnung.

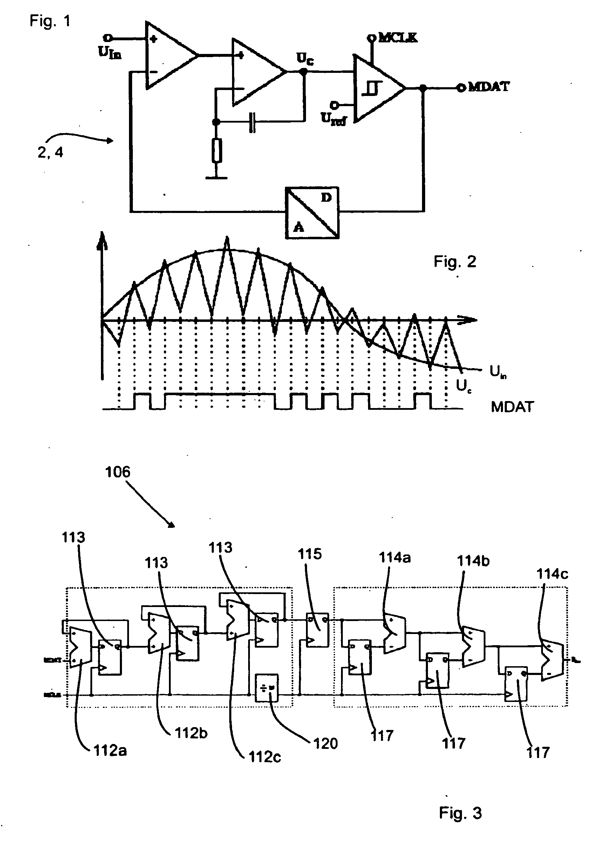

Fig. 1 zeigt ein Schaltbild eines Sigma-Delta-Modulators 2,4. Ein derartiger Sigma-Delta Modulator 2,4 dient dabei, wie oben erwähnt der Messung beispielsweise von Strömen und Spannungen und gibt Datenströme MDAT aus. Im Stand der Technik sind dabei derartige Sigma-Delta-Modulatoren jeweils einzelne Auswertelogiken nachgeschaltet. Damit sind im Stand der Technik einkanalige Realisierungen von derartigen Sinc-Filtern bekannt. Zur Auswertung mehrerer Sigma-Delta-Datenströme sind auch mehrere Sinc-Filter erforderlich.

Ein derartiger Sigma-Delta-Modulator weist überlicherweise einen Subtrahierer, eine Integrationseinheit, einen A/D-Wandler (in Form eines Komparators oder eines Bit-Quantisierers), zu, sowie einen rückgekoppelten D/A-Wandler auf. In Fig.1 ist daher der schematische Aufbau eines Modulators erster Ordnung dargestellt. Die Abtastung des analogen Eingangssignals $U_{in}$, welches die Bandbreite $f_{in}$ aufweist, erfolgt mit einer hohen Überabtastrate OSR (Over sampling rate) gleich $f_{MCLK}/2f_{in}$. Dabei bezeichnet $f_{MCLK}$ die Abtastfrequenz. Die jeweils in der Überabtastung aufeinanderfolgenden Bits der entstehenden seriellen Bit-Folge enthalten die Information, die nach dem sogenannten Nyquist-Kriterium zur Beschreibung eines Signals der Bandbreite $f_{in}$ erforderlich ist.

Figur 2 zeigt eine Darstellung zur Verarbeitung von Eingangssignalen. Dabei bezieht sich $U_{in}$ wiederum auf das Eingangssignal und $U_c$ auf das Signal, welches nach dem Integrationsglied ausgegeben wird. Das Bezugszeichen MDAT bezieht sich wiederum auf die ausgegebenen Daten, wobei diese jeweils mit einer logischen 1 belegt werden, wenn $U_c$ positiv ist und mit einer logischen 0, falls $U_c$ negativ ist, d.h. eine Referenzspannung ist hier die Figur 2 dargestellte 0 - Linie.

Fig. 3 zeigt einen Sinc-Filter dritter Ordnung nach dem Stand der Technik. Dieser Sinc-Filter weist dabei 3 Integrationsglieder 112a, 112b und 112c auf. Diesen Integrationsgliedern sind jeweils getaktete Speicherelemente 113 nachgeschaltet. An diesen Block dreier Integrationsglieder schließt sich eine Speichereinheit 115 an und an diese wiederum 3 Differenzierglieder 114a, 114b und 114c, wobei diesen einzelnen Differenzierglieder 114a, 114b, 114c jeweils Speichereinrichtungen 117 zugeordnet bzw. nachgeschaltet sind. Man erkennt, dass die einzelnen Speichereinrichtungen 117 jeweils mit den gleichen Takt belegt werden.

Der in Fig. 3 gezeigte Sinc -Filter führt auf dem seriellen Bitstrom eine gleitende Mittelwertbildung durch. Die Dezimation M bezeichnet dabei die Anzahl der akkumulieren Werte:

$$y(n) = \frac{1}{M} \sum_{i=0}^{M-1} x(n-m)$$

Damit ergibt sich die Übertragungsfunktion für einen Sinc - Filter der Ordnung k zu:

$$H(z) = \left( \frac{1}{M} \sum_{i=0}^{M-1} z^{-i} \right)^k = \left( \frac{1}{M} \cdot \frac{1-z^{-M}}{1-z^{-1}} \right)^k$$

Für den Frequenzgang ergibt sich dann mit $\omega = 2\pi f_g / f_{MCLK}$:

$$H(e^{j\omega}) = \left( \frac{1}{M} \cdot \frac{1-e^{-j\omega M}}{1-e^{-j\omega}} \right)^k = \left( \frac{1}{M} \cdot \frac{\sin \frac{\omega M}{2}}{\sin \frac{\omega}{2}} \right)^k$$

Zur Vermeidung von sog. Aliasing - Effekten wird bevorzugt die Ordnung k des Sinc - Filters einen Grad höher gewählt als jene des Sigma-Delta-Modulators.

Die untenstehende Tabelle verdeutlicht anhand eines Beispiels die sich ergebenden Patameter bzw. Werte:

| Ordnung $k$ | 3 | |
|---|---|---|
| Decimation $M$ | 16 | |
| Grenzfrequenz $f_g$ | 81,8 kHz | H ≈ 0.70 |
| Samplefrequenz $f_{MCLK}$ | 5 MHz | |
| Datenrate Filter | 312,5 kHz | = $f_{MCLK}$ / M |
| Max. Bandbreite Eingang $f_{IN}$ | 156,25 kHz | = $f_{MCLK}$ / 2*M |
| Bitbreite Filter $b$ | 13 | 1 + $k$*$\log_2 M$ |

Die Datenrate von 312,5 kHz entspricht jeweils einem neuen Datenwert am Filterausgang im Abstand von 3,2 μs.

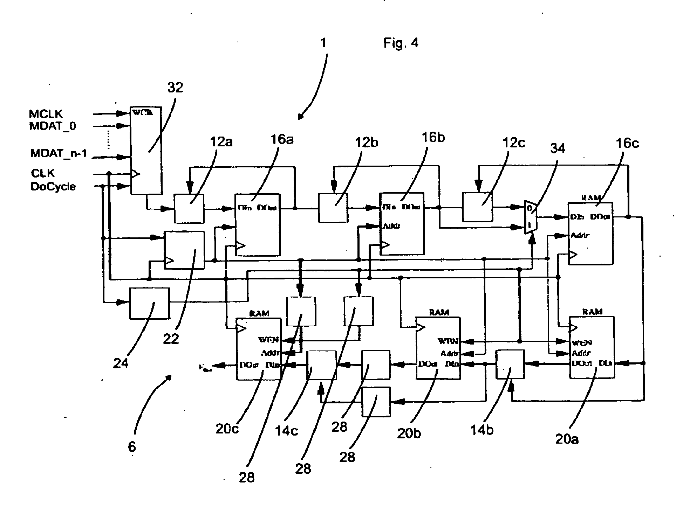

Fig. 4 zeigt ein Schaltbild eines erfindungsgemäßen Mehrkanal-Sinc-Filters. Dabei bezieht sich das Bezugszeichen 32 auf eine Speichereinrichtung, genauer ein Schieberegister, in welches die Bitströme *MDAT_0,...,MDAT_n-1* von *n* Sigma-Delta-Modulatoren (nicht gezeigt) geladen werden, damit diese Bitströme ausgewertet werden können. Die Modulatoren werden mit einem gemeinsamen Taktsignal *MCLK* der Frequenz $f_{MCLK}$ betrieben.

Die Speicherelemente der Filter-Implementierung (also Schieberegister, Datenregister (Flipflops und RAMs) werden mit einem schnellen Systemtakt *CLK* der Frequenz $f_{CLK}$ getaktet. Mit jeder steigenden Flanke des Taktsignales *MCLK* wird der n Systemtakte lange Impuls *"DoCycle"* erzeugt.

Das aktuelle Bit des Datenstromes jedes Sigma-Delta-Modulators wird mit der steigenden Taktflanke von *MCLK* parallel in ein Schieberegister der Bitbreite *n* geladen. Anschließend werden die Bitwerte der einzelnen Modulatoren im Takt *CLK* seriell dem ersten Integriererglied 12a zugeführt. Das Bezugszeichen 22 bezieht sich dabei auf eine Zähleinrichtung für die einzelnen Kanäle die ebenfalls mit dem Systemtakt CLK getaktet wird. Ein Ausgang dieser Zähleinrichtung ist mit dem Eingang einer adressierbaren Speichereinrichtung 16a verbunden wobei mit jedem Takt die Adresse dieser dem Integrationsglied 12a nachgeschalteten Speichereinrichtung 16a erhöht wird.

Die Speichereinrichtung 16a nimmt im CLK-Takt die *b* Bit breiten Resultate des Integrationsglieds 12a auf. Nach demselben Muster arbeiten die beiden weiteren Integrationsglieder 12b, 12c owie die diesen jeweils nachgeschalteten adressierbaren Speichereinrichtungen 16b, 16c.

Den drei Integriererstufen sind die Differenzierglieder 14b, 14c nachgeschaltet, welche mit einem Takt der Frequenz $f_{MCLK}$ / M arbeiten. Dieses Taktsignal wird durch einen Taktgeber 24 erzeugt. Dieses Taktsignal ist dabei ein *n* Systemtakte langer Impuls - analog zu "DoCycle" - mit dem Unterschied, dass er nur alle *M* Zyklen (*wobei M die Dezimation* des Filters bezeichnet) des Taktes MCLK auftritt.

Die Ansteuerung der Differenzierglieder 14b, 14c mit diesem Takt erfolgt genauer über die Schreibsignale der RAMs (WEN -write enable), so dass die RAMs in jedem *M*-ten Zyklus des Taktes *MCLK* den jeweils berechneten Zwischenwert aller Kanäle einspeichern.

Die Bezugszeichen 28 stellen jeweils Register dar. Diese Register dienen zur Verkürzung des kombinatorischen Pfades der Logik. Genauer werden hierbei alle Eingangswerte und - signale des letzten Differenzierglieds 14c bzw. des diesem nachgeschalteten adressierbaren Speicherelements 20c über die besagten Register 28 geführt und damit um einen Takt verzögert. Auf diese Weise wird ein höherer Systemtakt ermöglicht.

Das Bezugszeichen 34 zeigt einen Multiplexer, der dem dritten Integrationsglied 12c nachgeschaltet ist. Dieser Multiplexer 34 wird dabei mit dem Takt $f_{MCLK}$ / M betrieben. Der Multiplexer 34 bewirkt, dass nach Ablauf jedes "M-Cycles" (d.h. stets nach M Zyklen des Taktes MCLK) der im RAM d.h. der Speichereinrichtung 16c gehaltene Zwischenwert des dritten Integrierglieds 12c resetiert wird. Auf diese Weise kann eine Speichereinrichtung am Übergang von Integrations- zum Differentiationsteil des Filters (wie sie in Fig. 3 mit dem Bezugszeichen 115 dargestellt ist) vermieden werden. Daneben kann durch die nicht propagierte Akkumulation des letzten Integrierglieds 12c nach Ablauf jedes M-Zyklus auch das erste Differenzierglied (welches bei der Vorrichtung nach dem Stand der Technik, vgl. Fig. 3, das Bezugszeichen 114a trägt) eingespart werden.

Weiterhin wäre es auch möglich, sog. FPGA - Elemente (Field programmable gate array) einzusetzen, welche LUTRAMs (look-up-table RAM) unterstützen. Bei diesen LUTRAMs handelt es sich um ressourceneffiziente SRAM - Speichereinrichtungen für FGPA - Elemente, welche beispielsweise mittels FPGA - Logikzellen realisiert werden können.

Insgesamt ist durch die vorliegende Erfindung eine Einsparung von Ressourcen bei programmierbarer Logik möglich.

Sämtliche in den Anmeldungsunterlagen offenbarten Merkmale werden als erfindungswesentlich beansprucht, sofern sie einzeln oder in Kombination gegenüber dem Stand der Technik neu sind.

# EP 2 175 287 B1

**Bezugzeichenliste**

| | |
|---|---|
| 1 | Vorrichtung |
| 2 | erste Wandlereinrichtung |
| 4 | zweite Wandlereinrichtung |
| 6 | Auswertelogik |
| 12a, 12b, 12c | Integrationsglieder |
| 14b, 14c | Differenzierglieder |
| 16a, 16b, 16c | adressierbare Speicherelemente |
| 20a, 20b, 20c | weitere adressierbare Speicherelemente |
| 22 | Kanalzähler |
| 24 | Taktgeber |
| 28 | Register |
| 32 | Speichereinrichtung, Schieberegister |
| MDAT_0, ... MDAT_n-1 | digitale Daten |
| $U_{in}$ | analoge Signale |
| $f_{in}$ | Bandbreite |
| CLK | Systemtakt |
| $f_{CLK}$ | Frequenz des Systemtakts |
| DoCycle | Impuls |
| MCLK | Taktsignal |

**Patentansprüche**

1. Vorrichtung (1) zur Messung elektrischer Kenngrößen, mit einer ersten Wandlereinheit (2), welche analoge Signale (U in) in erste digitale Daten (MDAT_1) umwandelt, wobei die erste Wandlereinheit (2) ein Sigma-Delta-Modulator (2) ist, mit einer zweiten Wandlereinheit (4), welche analoge Signale (U1) in zweite digitale Daten (MDAT_2) umwandelt, wobei die zweite Wandlereinheit (4) ein Sigma -Delta- Modulator (4) ist und mit wenigstens einer Auswertelogik (6) zur Bearbeitung der von den Wandlereinheiten (2, 4) ausgegebenen Daten (MDAT_1, MDAT_2), wobei die Auswertelogik (6) wenigstens ein Integrationsglied (12a, 12b, 12c) und ein diesem Integrationsglied (12a, 12b, 12c) nachgeschaltetes Differenzierglied (14b, 14c) aufweist
**dadurch gekennzeichnet, dass**
die Auswertelogik (6) die digitalen Daten (MDATL1, MDAT_2) beider Wandlereinheiten (2, 4) bearbeitet und die Wandlereinheiten (2, 4) jeweils Eingänge für ein Taktsignal aufweisen, wobei eine Taktgebereinrichtung vorgesehen ist, welche die erste Wandlereinheit (2) und die zweite Wandlereinheit (4) in einem vorgegebenen Verhältnis zueinander taktet.

2. Vorrichtung (1) nach Anspruch 1,
**dadurch gekennzeichnet, dass**
die Auswertelogik (6) wenigstens ein adressierbares Speicherelement (16a, 16b, 16c) aufweist.

3. Vorrichtung nach Anspruch 2,
**dadurch gekennzeichnet, dass**
das adressierbare Speicherelement (16a, 16b, 16c) einem integrationsglied (12a, 12b, 12c) der Auswertelogik (6) nachgeschaltet ist.

4. Vorrichtung nach wenigstens einem der vorangegangenen Ansprüche,
**dadurch gekennzeichnet, dass**
mehrere adressierbare Speicherelemente (16a, 16b, 16c) vorgesehen sind und diese Speicherelemente (16a, 16b, 16c) mit einem gleichen Takt betrieben werden.

5. Vorrichtung (1) nach wenigstens einem der vorangegangenen Ansprüche,
**dadurch gekennzeichnet, dass**
die Auswertelogik (6) ein Sinc - Filter (6) mit einer Ordnung (k) aufweist, wobei k größer als 1 ist.

**6.** Vorrichtung nach wenigstens einem der vorangegangenen Ansprüche,
**dadurch gekennzeichnet, dass**
die Wandlereinheiten (2, 4) gleich getaktet sind.

**7.** Vorrichtung nach wenigstens einem der vorangegangenen Ansprüche, **dadurch gekennzeichnet, dass** die Vorrichtung eine Speichereinrichtung zum vorübergehenden Speichern der digitalen Daten (MDAT_1, MDAT_2) aufweist.

**8.** Vorrichtung nach wenigstens einem der vorangegangenen Ansprüche,
**dadurch gekennzeichnet, dass**
die Auswertelogik mehrere Integrationseinheiten (12a, 12b, 12c) aufweist und jeder Integrationseinheit jeweils ein adressierbares Speicherelement (16a, 16b, 16c) nachgeschaltet ist

**9.** Vorrichtung nach wenigstens einem der vorangegangenen Ansprüche,
**dadurch gekennzeichnet, dass**
wenigstens ein einem Differenzierglied (14b, 14c) nachgeschaltetes weiteres adressierbares Speicherelement (20a, 20b, 20c) mit einem anderen Takt betrieben wird, als ein adressierbares Speicherelement (16a,1 .6b, 16c).

**10.** Vorrichtung nach wenigstens einem der vorangegangenen Ansprüche,
**dadurch gekennzeichnet, dass**
zwischen den Integrationsgliedern (12a, 12b, 12c) und den Differenziergliedem (14a, 14b, 14c) ein Multiplexer (34) angeordnet ist.

**11.** Verfahren zur Bestimmung elektrischer Kenngrößen mit den Schritten:

- Bereitstellung mehrerer digitaler Daten (MDAT_1, MDAT_2), welche für die elektrischen Kenngrößen charakteristisch sind durch wenigstens eine erste Wandlereinrichtung (2) und wenigstens eine zweite Wandlereinrichtung (4);
- Zuführung der digitalen Daten (MDAT_1, MDAT_2) an eine Auswertelogik, welche wenigstens ein Integrationsglied (12a, 12b, 12c) und wenigstens ein diesem Integrationsglied (12a, 12b, 12c) nachgeschaltetes Differenzierglied (14a, 14b, 14c) aufweist und Bearbeitung der Daten durch die Auswertelogik;
- Ausgabe eines Signals durch die Auswertelogik, wobei dieses Signal für die elektrische Kenngröße charakteristisch ist,

**dadurch gekennzeichnet, dass**
die Auswertelogik (6) die digitalen Daten (MDAT_1, MDAT_2) beider Wandlereinheiten (2, 4) bearbeitet und die Wandlereinheiten (2, 4) jeweils Eingänge für ein Taktsignal aufweisen, wobei eine Taktgebereinrichtung (10) die erste Wandlereinheit (2) und die zweite Wandlereinheit (4) in einem vorgegebenen Verhältnis zueinander taktet.

**12.** Verfahren nach Anspruch 11,
**dadurch gekennzeichnet, dass**
die Daten (MDAT_1; MDAT_2) mehrerer Wandlereinrichtungen (2,4) parallel in ein Schieberegister (32) geladen werden.

**13.** Verfahren nach wenigstens einem der vorangegangenen Ansprüche 11 - 12,
**dadurch gekennzeichnet, dass**
die Daten (MDAT_1; MDAT_2) oder aus diesen Daten abgeleitete Daten einem ersten Integrationsglied (12a, 12b, 12c) getaktet zugeführt werden, wobei mit jedem Takt eine Adresse einer diesem Integrationsglied nachgeschalteten adressierbaren Speichereinrichtung (16a. 16b, 16c) verändert wird.

**14.** Verfahren nach wenigstens einem der vorangegangenen Ansprüche 11 - 13,
**dadurch gekennzeichnet, dass**
wenigstens eine einem Differenzierglied (14b, 14c) nachgeschaltete weitere Speichereinrichtung (20b, 20c) mit einem anderen Takt betrieben wird als die adressierbare Speichereinrichtung (16a, 16b, 16c).

**Claims**

1. Apparatus (1) for measuring electrical characteristic variables, having a first converter unit (2) which converts analogue signals (U in) into first digital data (MDAT_1), the first converter unit (2) being a sigma-delta modulator (2), having a second converter unit (4) which converts analogue signals (U 1) into second digital data (MDAT_2), the second converter unit (4) being a sigma-delta modulator (4), and having at least one evaluation logic unit (6) for processing the data (MDAT_1, MDAT_2) output by the converter units (2, 4), the evaluation logic unit (6) having at least one integration element (12a, 12b, 12c) and a differentiating element (14b, 14c) downstream of this integration element (12a, 12b, 12c),
**characterized in that**
the evaluation logic unit (6) processes the digital data (MDAT_1, MDAT_2) from both converter units (2, 4) and the converter units (2, 4) each have inputs for a clock signal, a clock generator device being provided, which clock generator device clocks the first converter unit (2) and the second converter unit (4) in a predefined ratio with respect to one another.

2. Apparatus (1) according to Claim 1,
**characterized in that**
the evaluation logic unit (6) has at least one addressable memory element (16a, 16b, 16c).

3. Apparatus according to Claim 2,
**characterized in that**
the addressable memory element (16a, 16b, 16c) is downstream of an integration element (12a, 12b, 12c) of the evaluation logic unit (6).

4. Apparatus according to at least one of the preceding claims,
**characterized in that**
a plurality of addressable memory elements (16a, 16b, 16c) are provided and these memory elements (16a, 16b, 16c) are operated with the same clock.

5. Apparatus (1) according to at least one of the preceding claims,
**characterized in that**
the evaluation logic unit (6) has a sinc filter (6) with an order (k), with k being greater than 1.

6. Apparatus according to at least one of the preceding claims,
**characterized in that**
the converter units (2, 4) are clocked in the same manner.

7. Apparatus according to at least one of the preceding claims, **characterized in that** the apparatus has a memory device for temporarily storing the digital data (MDAT_1, MDAT_2).

8. Apparatus according to at least one of the preceding claims,
**characterized in that**
the evaluation logic unit has a plurality of integration units (12a, 12b, 12c) and a respective addressable memory element (16a, 16b, 16c) is downstream of each integration unit.

9. Apparatus according to at least one of the preceding claims,
**characterized in that**
at least one further addressable memory element (20a, 20b, 20c) downstream of a differentiating element (14b, 14c) is operated with a different clock than an addressable memory element (16a, 16b, 16c).

10. Apparatus according to at least one of the preceding claims,
**characterized in that**
a multiplexer (34) is arranged between the integration elements (12a, 12b, 12c) and the differentiating elements (14a, 14b, 14c).

11. Method for determining electrical characteristic variables, having the following steps:

- at least one first converter device (2) and at least one second converter device (4) provide a plurality of digital data items (MDAT_1, MDAT_2) which are characteristic of the electrical characteristic variables;
- the digital data (MDAT_1, MDAT_2) are supplied to an evaluation logic unit having at least one integration element (12a, 12b, 12c) and at least one differentiating element (14a, 14b, 14c) downstream of this integration element (12a, 12b, 12c) and the evaluation logic unit processes the data;
- the evaluation logic unit outputs a signal, this signal being characteristic of the electrical characteristic variable,

**characterized in that**
the evaluation logic unit (6) processes the digital data (MDAT_1, MDAT_2) from both converter units (2, 4) and the converter units (2, 4) each have inputs for a clock signal, a clock generator device (10) clocking the first converter unit (2) and the second converter unit (4) in a predefined ratio with respect to one another.

**12.** Method according to Claim 11,
**characterized in that**
the data (MDAT_1; MDAT_2) from a plurality of converter devices (2, 4) are loaded into a shift register (32) in a parallel manner.

**13.** Method according to at least one of the preceding Claims 11-12,
**characterized in that**
the data (MDAT_1; MDAT_2) or data derived from these data are supplied to a first integration element (12a, 12b, 12c) in a clocked manner, an address of an addressable memory device (16a, 16b, 16c) downstream of this integration element being changed with each clock.

**14.** Method according to at least one of the preceding Claims 11-13,
**characterized in that**
at least one further memory device (20b, 20c) downstream of a differentiating element (14b, 14c) is operated with a different clock than the addressable memory device (16a, 16b, 16c).

**Revendications**

**1.** Dispositif (1) pour la mesure de grandeurs électriques caractéristiques, présentant
une première unité de conversion (2) qui convertit des signaux analogiques (U in) en premières données numériques (MDAT_1), la première unité de conversion (2) étant un modulateur sigma-delta (2),
une deuxième unité de conversion (4) qui convertit les signaux analogiques (U 1) en deuxièmes données numériques (MDAT_2), la deuxième unité de conversion (4) étant un modulateur sigma-delta (4) et
au moins une logique d'évaluation (6) qui traite les données (MDAT_1, MDAT_2) délivrées par les unités de conversion (2, 4),
la logique d'évaluation (6) présentant au moins un organe d'intégration (12a, 12b, 12c) et un organe de différentiation (14b, 14c) raccordé en aval de cet organe d'intégration (12a, 12b, 12c),
**caractérisé en ce que**
la logique d'évaluation (6) traite les données numériques (MDAT_1, MDAT_2) des deux unités de conversion (2, 4) et les unités de conversion (2, 4) présentent chacune des entrées pour un signal d'horloge,
**en ce qu'**un dispositif de formation d'un signal d'horloge est prévu pour cadencer l'une par rapport à l'autre la première unité de conversion (2) et la deuxième unité de conversion (4) dans un rapport prédéterminé.

**2.** Dispositif (1) selon la revendication 1, **caractérisé en ce que** la logique d'évaluation (6) présente au moins un élément adressable de mémoire (16a, 16b, 16c).

**3.** Dispositif selon la revendication 2, **caractérisé en ce que** l'élément adressable de mémoire (16a, 16b, 16c) est raccordé en aval d'un organe d'intégration (12a, 12b, 12c) de la logique d'évaluation (6).

**4.** Dispositif selon au moins l'une des revendications précédentes, **caractérisé en ce que** plusieurs éléments adressables de mémoire (16a, 16b, 16c) sont prévus et **en ce que** ces éléments de mémoire (16a, 16b, 16c) sont conduits à la même cadence.

**5.** Dispositif (1) selon au moins l'une des revendications précédentes, **caractérisé en ce que** la logique d'évaluation (6) présente un filtre Sinc (6) d'ordre (k), k étant plus grand que 1.

**6.** Dispositif selon au moins l'une des revendications précédentes, **caractérisé en ce que** les unités de conversion (2, 4) sont conduites à la même cadence.

**7.** Dispositif selon au moins l'une des revendications précédentes, **caractérisé en ce que** le dispositif présente un dispositif de mémoire qui permet de conserver temporairement en mémoire les données numériques (MDAT_1, MDAT_2).

**8.** Dispositif selon au moins l'une des revendications précédentes, **caractérisé en ce que** la logique d'évaluation présente plusieurs unités d'intégration (12a, 12b, 12c), chaque unité d'intégration étant suivie par un élément adressable de mémoire (16a, 16b, 16c).

**9.** Dispositif selon au moins l'une des revendications précédentes, **caractérisé en ce qu'**un autre élément adressable de mémoire (20a, 20b, 20c) raccordé en aval d'un organe de différentiation (14b, 14c) est conduit à une autre cadence qu'un élément adressable de mémoire (16a, 16b, 16c).

**10.** Dispositif selon au moins l'une des revendications précédentes, **caractérisé en ce qu'**un multiplexeur (34) est disposé entre les organes d'intégration (12a, 12b, 12c) et les organes de différentiation (14a, 14b, 14c).

**11.** Procédé de détermination de grandeurs électriques caractéristiques, le procédé comportant les étapes qui consistent à :

faire préparer plusieurs données numériques (MDAT_1, MDAT_2) caractéristiques des grandeurs électriques caractéristiques par au moins un premier dispositif de conversion (2) et au moins un deuxième dispositif de conversion (4),
apporter les données numériques (MDAT_1, MDAT_2) à une logique d'évaluation qui présente au moins un organe d'intégration (12a, 12b, 12c) et au moins un organe de différentiation (14a, 14b, 14c) raccordé en aval de cet organe d'intégration (12a, 12b, 12c) et traiter les données à l'aide de la logique d'évaluation,
faire délivrer un signal par la logique d'évaluation, ce signal étant caractéristique de la grandeur électrique caractéristique,
**caractérisé en ce que**
la logique d'évaluation (6) traite les données numériques (MDAT_1, MDAT_2) des deux unités de conversion (2, 4),
**en ce que** chacune des unités de conversion (2, 4) présente une entrée pour un signal d'horloge et
**en ce qu'**un dispositif de cadençage (10) cadence la première unité de conversion (2) et la deuxième unité de conversion (4) dans un rapport prédéterminé.

**12.** Procédé selon la revendication 11, **caractérisé en ce que** les données (MDAT_1, MDAT_2) de plusieurs dispositifs de conversion (2, 4) sont chargées en parallèle dans un registre glissant (32).

**13.** Procédé selon au moins l'une des revendications 11 et 12 qui précèdent, **caractérisé en ce que** les données (MDAT_1, MDAT_2) ou des données dérivées de ces données sont apportées de manière cadencée à un premier organe d'intégration (12a, 12b, 12c), l'adresse d'un dispositif adressable de mémoire (16a, 16b, 16c) raccordé en aval de cet organe d'intégration étant modifiée lors de chaque cadence.

**14.** Procédé selon au moins l'une des revendications 11 à 13, **caractérisé en ce qu'**au moins un autre dispositif de mémoire (20b, 20c) raccordé en aval de l'organe de différentiation (14b, 14c) est conduit à une autre cadence que le dispositif adressable (16a, 16b, 16c).

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **SREELAL S P et al.** A high resolution, integrated data acquisition system for aerospace applications. *DIGITAL AVIONICS SYSTEMS CONFERENCE,* 24. Oktober 2004, ISBN 978-0-7803-8539-9, 13.E.3-131